Europäisches Patentamt

European Patent Office

Office européen des brevets

(11) Publication number: **0 628 830 A2**

# EUROPEAN PATENT APPLICATION

(21) Application number: **94302365.5**

(51) Int. Cl.⁵: **G01R 31/26**

(22) Date of filing: **31.03.94**

(30) Priority: **11.06.93 JP 36903/93**

(43) Date of publication of application:
**14.12.94 Bulletin 94/50**

(84) Designated Contracting States:
**DE DK FR GB IT SE**

(71) Applicant: **Sumitomo Electric Industries, Ltd.**
**5-33, Kitahama 4-chome, Chuo-ku**
**Osaka 541 (JP)**

(72) Inventor: **Fujimara, Yasushi, c/o Osaka Works**
**of Sumitomo**
**Elec. Ind., Ltd,**
**1-3, Shimaya 1-chome,**
**Konahara-ku**
**Osaka (JP)**

Inventor: **Yoshimura, Manabu, c/o Osaka**
**Works of Sumitomo**
**Elec. Ind., Ltd,**
**1-3, Shimaya 1-chome,**
**Konahara-ku**
**Osaka (JP)**
Inventor: **Terauchi, Hitoshi, c/o Osaka Works**
**of Sumitomo**
**Elec. Ind., Ltd,**
**1-3, Shimaya 1-chome,**
**Konahara-ku**
**Osaka (JP)**

(74) Representative: **Smith, Norman Ian et al**
**F.J. CLEVELAND & COMPANY**
**40-43 Chancery Lane**
**London WC2A 1JO (GB)**

(54) **Reliability tester of semiconductor lasers.**

(57) Conventionally Ge photodiodes have been employed as photodetectors for the reliability test of the semiconductor lasers of a 1.0 $\mu$m and 1.6 $\mu$m wavelength, since Ge photodiodes have wide receiving regions with high sensitivity for the range of wavelength. A large dark current flows in a Ge photodiode at a high temperature. Thus, Ge photodiodes must be cooled. Also the sample lasers are heated to accelerate the test. The lasers and the Ge photodiodes require two independent thermostats, and fiber rods are used to connect the Ge photodiodes to the lasers. The present invention uses InGaAs photodiodes (21) as photodetectors. The InGaAs photodiodes (21) and sample lasers (11) can be placed face to face in the same thermostat (1). Several pairs of a laser and a InGaAs photodiode can be aligned in the axial direction in the thermostat. A saving in the packing space per sample increases the number of lasers which can be examined in a test cycle.

FIG. 2

This application claims the priority of Japanese Utility Model Application No.36903/1993 filed June 11, 1993, which is incorporated herein by reference.

This invention relates to a testing device of reliability of a semiconductor lasers which are used as light sources of optoelectronic communications. The semiconductor lasers for the optoelectronic communications emit light beams of a wavelength of 1.0 $\mu$m to 1.6 $\mu$m. The lasers are fabricated from the semiconductor of InP. Reliability test is a procedure for examining long-term variations of emission property. Thus the reliability test reveals the time-dependent degradation of lasers. The reliability test comprises the steps of disposing semiconductor lasers in the vessel at a high temperature, applying driving currents to the lasers, measuring the light power emitted from the lasers by photodetectors and recording the time dependent change of the emission efficiency of the lasers.

The reliability test of semiconductor lasers requires a photodetector for monitoring the light power. The photodetector must receive most of light beams emitted from the laser, since the total light power is important for estimating the reliability. In general, laser diodes have wide aperture angles. Conventional reliability tests have employed germanium (Ge) photodiodes for detecting light emission of lasers. A Ge photodiode has a wide light receiving area. The wide receiving area allows the Ge diode to gather almost all light beams emitted from a laser and measure nearly total power of the beams. However germanium diodes are afflicted with the drawbacks of a large dark current and its big variation caused by temperature change.

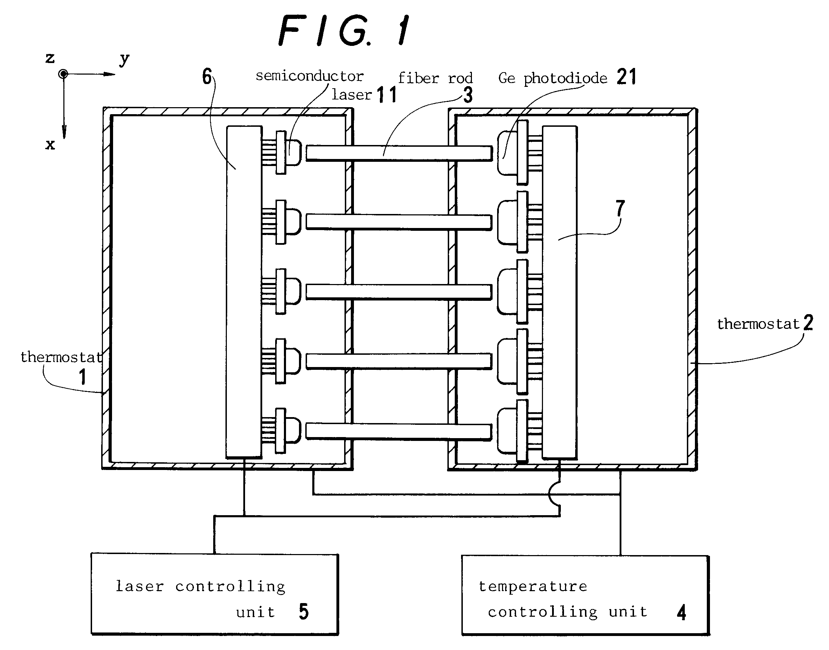

Fig.1 shows a plan view of a conventional tester of reliability of a laser. The test device comprises two thermostats (1) and (2). A thermostat is a closed vessel whose temperature can be adjusted at an arbitrary, preset temperature. First thermostat (1) is provided with a plurality of laser diodes (11) to be tested. Second thermostat (2) maintains the same number of germanium (Ge) photodiodes (21). The emission outputs of the semiconductor lasers (11) are optically connected to the receiving input of the Ge photodiodes (21) by fiber rods (3). The temperatures of the two thermostats (1) and (2) are adjusted independently by a temperature controlling unit (4). The conventional reliability tester demands two independent thermostats, because the Ge photodiodes require a temperature of environment different from that of the laser diodes. In short, the Ge photodiodes must be cooled but the lasers must be heated in the tester.

The laser diodes are fixed to a laser circuit plate (6) in the laser thermostat (1). The Ge photodiodes are furnished to a photodiode circuit plate (7) in the photodiode thermostat (2). Laser diode controlling unit (5) is connected to the laser diodes (11) and the Ge photodiodes (21) for adjusting the driving current of the laser diodes (11) or the photocurrent of the photodiodes (21).

Currents are applied to the laser diodes through the printed circuits on the plate (6). The laser diodes emanate light beams. The light beams are introduced into the Ge photodiodes (21) through the fiber rods (3). The driving currents of the laser diodes are adjusted for maintaining the light power at a constant level. A reciprocal of the driving current signifies the emission performance of the laser in this case. Otherwise the light power is monitored at a constant driving current. The light power denotes the emission property in this case. In any cases, the tester examines the long-term variations of the emission efficiency of the laser diodes. Reliability means the resistance against the degradation caused by a long-term use.

In general, the reliability of laser diodes is examined either by estimating the change of light power at a constant driving current or by estimating the change of driving current at a constant light output power. The former method is called an automatic current control mode (ACC), because the current is kept constant. The latter is called an automatic power control mode (APC), since the power is maintained to be constant. The emission property is measured at a high temperature instead of room temperature. The high temperature enables the tester to shorten the test time by accelerating the degradation of laser diodes. Both the ACC mode and APC mode demand highly sensitive photodiodes for monitoring the variations of the light power of laser diodes with a small error less than several percent.

The photodiodes must receive almost all light beams of the lasers, since the reliability test examines the change of the whole light power as a function of time. The beams emitted from a laser form a light cone whose top coincides with the emission end of the laser. The light cone, the beam diameter or the aperture of light is defined as the area which contains 70 % of light energy. The diameter of the light beams is increasing according to the distance from the laser. The light cone has wide aperture angles. Separation of the photodiode from the laser diode enlarges the beam diameter. A wide beam diameter requires a wide receiving area of the photodiode. The beam diameter is equal to the product of the aperture angle of the far field pattern (FFP) by the distance from the laser diode chip.

Approach of the photodiode to the laser should decrease the beam diameter at the photodiode. However both the laser and the photodiode are stored in packages. The existence of the packages prevents the photodiode from approaching the laser diode less than about 3 mm. Around 3 mm is the minimum distance between the laser chip and the photodiode chip in any cases.

Here the distance means the sum of the length between the fiber end and the laser and the length between the other fiber end and the photodetector. H denotes the actual distance between the laser and the photodiode and K signifies the length of the fiber rod. Thus the distance L means the difference between H and K (L = H-K), when the photodiode is connected to the laser by the fiber rod.

Generally the far field pattern (FFP) of semiconductor lasers has nearly 30 degrees of an aperture angle. The beams diverge from the laser. The beam diameter attains 3 mm at the distance of 3 mm; the minimum distance, even if the beams are localized at a spot on the emission surface of the laser. Reception of more than 70 % of the light power requires a photodiode having a receiving area of a diameter more than 3 mm.

Now the problems of photodiodes are clarified. The optoelectronic communication relies on the light of a wavelength of 1.0 $\mu$m to 1.6 $\mu$m. Since the reliability tester examines the laser diodes which emit the light of a 1.0 $\mu$m to 1.6 $\mu$m wavelength, the photodetector must have sufficient sensitivity for the wavelength between 1.0 $\mu$m and 1.6 $\mu$m. Ge photodiodes excel in the sensitivity for the range of wavelength. Furthermore Ge is a suitable material for fabricating photodiodes with a wide receiving area. Since the photodiode for the reliability test must gather almost all light beams emitted from a laser diode, the most important requirement is a wide receiving area. Thus Ge photodiodes have been exclusively used for testing the laser diodes of a 1.0 $\mu$m to 1.6 $\mu$m wavelength, because Ge photodiodes are superior to other kinds of photodiodes in the width of the receiving area. It is easy to produce wide Ge diodes having a receiving area of a diameter of 3 mm to 10 mm. A Ge photodiode can collect nearly all light beams emanated from laser without a lens. Ge photodiodes have an advantage of the larger width of the light receiving area than any other types of photodiodes.

However big dark currents accompany Ge photodiodes. Since a photodiode is reversely biased, a small current leaks through a pn junction. The leak current flows also when no light beams radiate the photodiode. Thus the leak current is called a dark current. The dark current disturbs the measurement as noise. The dark current greatly varies by the change of temperature. The higher the temperature rises, the bigger the dark current becomes. The dark current increases conspicuously at a high temperature. The current of a photodiode is a sum of a photocurrent and a dark current. The photocurrent is the signal which varies in proportion to the light power. The dark current is the noise which changes according to the temperature. Big dark currents prevent Ge photodiodes from detecting the light beams precisely. For example, a Ge photodiode with a receiving area of a 3 mm diameter invites a big dark current of several milliamperes at a reverse bias of 1 V at a temperature of 85 °C which is a typical temperature for reliability tests of semiconductor lasers. Several milliamperes are commensurate with the photocurrent induced by the light power emitted from a laser diode. Such a big dark current forbids the Ge photodiode from measuring the light power precisely. Namely Ge photodiodes cannot be employed at such a high temperature. Ge photodiodes must be cooled down to room temperature or less than room temperature in order to suppress the dark current. Therefore the thermostat (2) for the Ge photodiodes is maintained at room temperature or below room temperature by some cooling device. Besides, the temperature of the photodiodes must be rigorously controlled at a determined value, because the dark current varies as a function of temperature.

On the contrary, the laser diodes require an accelerated test in order to curtail the test time and to obtain the test result in a short time. The acceleration test is done under a bad condition of a high temperature. The higher the temperature rises, the more swiftly laser diodes deteriorate. In general, laser diodes have been examined in a heated condition up to 70 °C to 100 °C. In a typical case, the laser diodes are kept at 85 °C in the test device. The thermostat (1) for laser diodes can be heated and maintained at a high temperature in the range between 50 °C and 120 °C in Fig.1. Ordinary temperature of the reliability test is 70 °C to 100 °C.

The contradictory requirements demand two independent thermostats (1) and (2) in the tester. Laser diodes must be heated, but Ge photodiodes must be cooled. The provision of two thermostats raises the cost of the reliability tester. Since the laser diodes and the Ge photodiodes are separately furnished in two different thermostats, fiber rods (3) must be upholstered between two thermostats (1) and (2) in order to connect the sample lasers (11) with the photodiodes (21). The fiber rods (3) are optical fibers of a diameter of about 5mm. The coupling of the lasers and the photodiodes requires the same number of fiber rods as the lasers. The fiber rods (3) heighten the cost of the test machine further.

Another problem is the low density of samples in the tester or the small number of samples which are dealt with once in the tester. Semiconductor lasers are disposed at two-dimensionally distributed spots in the print circuit plate (6) of the laser thermostat (1). The photodiodes are also two-dimensionally distributed in the print circuit plate (7) of the second thermostat. The fiber rods (3) are arranged at two-dimensional positions in an imaginary plane vertical to the rods. Three dimensional coordinate is defined for the convenience of explanation in Fig.1. Y-axis is parallel with the fiber rods (3). Y-direction is called an axial direction, because the light beams progress in the direction. An XZ-plane is parallel with the print circuit plates (6) and (7). The lasers (11), photodiodes (21) and fiber rods (3) are arranges periodically with a cycle of 20 mm to 30 mm in an XZ-plane. Since the fiber rods (3) must couple the samples with the photodetectors (21) along Y-axis, more than one sample laser cannot be aligned in Y-direction. The necessity of two thermostats prevents the samples from being distributed in three dimensional space. The samples are only disposed in the XZ-plane. M denotes the number of the sample lasers in X-direction. N demotes the number of the samples in Z-direction. MN lasers are examined at a test cycle in the tester.

The size of the XZ-wall of the thermostats must be enhanced in order to increase the number of the laser samples which are tested in one cycle of test. However the extension in Y-direction (axial direction) of the vessels (thermostats) is not fully exploited even in the improvement, because no more than one sample can be aligned in Y-direction.

The fiber rods (3) are about 30 mm to 50 mm in length. Thus the full length between the outer XZ wall of the vessel (1) and the outer XZ wall of the vessel (2) attains about 500 mm. Two vessels and the fiber rods elongate the tester in Y-direction. But the number of the sample lasers is restricted by the area of the XZ walls of the vessels (1) and (2). Although the tester includes two bulky vessels, small number of samples can be examined at a cycle by the conventional tester.

A purpose of the invention is to provide a reliability tester for semiconductor lasers which alleviates the test cost per sample.

Another purpose is to provide a reliability tester for semiconductor lasers which is superior in the storage density of samples.

Another purpose is to provide a reliability tester which abates the cost of production.

A reliability tester of this invention uses InGaAs photodiodes as photodetectors. The InGaAs photodiodes are installed in the same thermostat that contains the sample lasers. Each InGaAs photodiode faces one laser sample in the thermostat. The light beams emitted from a laser directly attain the corresponding InGaAs photodiode without fiber rod. When the receiving area of the photodiode is narrow, it is preferable to interpose a lens between the emanating end of the laser and the receiving area of the InGaAs photodiode for converging the beams on the narrow receiving area. If the photodiode has a satisfactory wide receiving area, the photodiode dispenses with a lens.

Namely the reliability tester comprises a thermostat for storing sample lasers, a plurality of InGaAs photodiodes installed in the thermostat for monitoring the light beams emanated by the sample lasers, a controller of the temperature of the thermostat, a driver device for supplying driving currents to the lasers and a monitor device for measuring photocurrents of the InGaAs photodiodes. The reliability is defined by the degree of long-term degradation of the emission property of laser diodes. The change of the emission property is obtained either from the change of the driving currents for keeping the light power at a constant or from the change of the light power at a constant driving current. Preferably the photodiodes and the counterparts are provided with lenses for converging the light beams.

The features of the invention are:
① InGaAs photodiodes are employed as photodetectors instead of Ge photodiodes.
② Photodiodes are installed in the vicinity of the samples in the same thermostat, being directed to the counterparts with a small distance.
③ No fiber rod is adopted.
④ Interposition of a lens between the lasers and photodiodes is desirable, if the photodiodes have narrow receiving area.

The principle and function are clarified now. Besides Ge photodiodes, InGaAs photodiodes have also good sensitivity for the light of a wavelength of the range between 1.0 $\mu$m and 1.6 $\mu$m. Despite the high sensitivity, InGaAs photodiodes have never been utilized for testing the reliability of the laser diodes because of the narrow receiving area.

The reliability tester demands a big area of the receiving region for the photodetectors. Only Ge photodiodes satisfy the demand of the width of the receiving region. Since InGaAs is a ternary mixture crystal, it is difficult to grow a large InGaAs single crystal having a wide area without defects. The difficulty of the crystal growth has prevented InGaAs semiconductor from making a photodiode with a large receiving area.

Recent development of the crystal growth technology enables InGaAs semiconductor to make big photodiodes having a wide receiving area of a diameter of 1 mm to 3 mm. As mentioned before, the minimum breadth of the receiving area is 3 mm for the photodiode of the reliability test. InGaAs photodiodes have attained the minimum of available areas for the photodiodes for the reliability test for the first time. Ge photodiodes enjoy a wide area of a diameter of 3 mm to 10 mm. Although InGaAs photodiodes are still inferior in the area to Ge photodiodes, InGaAs photodiodes have acquired the possibility of being the photodetectors of the reliability test. The narrowness of the receiving area can be compensated by bringing the photodiodes nearer to the lasers. Approach to the lasers allows the InGaAs photodiodes to receive almost all light beams emanated from the lasers. Ge photodiodes have entirely prohibited themselves from approaching the lasers, because the photodiodes and lasers were stored in different thermostats.

On the contrary, InGaAs photodiodes can be installed in the same thermostat that contains the sample lasers. The InGaAs photodiodes can coexist with the lasers in the same thermostat. The coexistence allows the lasers to approach the counterparts without limit. The approach alleviates the drawback of the narrowness of the area of InGaAs photodiodes. If the receiving area is still insufficient, it is useful to interpose a lens between the laser and the counterpart.

The advantage of the InGaAs photodiodes is a small dark current and a small variation of the dark current due to the temperature change. This invention makes use of the advantages of the InGaAs photodiodes; the small dark current and its small change by temperature fluctuation. The dark current is only hundreds of nanoamperes (nA) in the InGaAs photodiode at a reverse bias of 1 V at 85°C which is a typical temperature of the reliability test. The dark current of an InGaAs photodiode is only $10^{-4}$ of the dark current (several milliamperes) of a Ge photodiode under the same condition.

Since the dark current is far smaller than the photocurrent and is nearly independent of temperature, the InGaAs photodiodes can be installed in the same thermostat which contains the sample lasers. The InGaAs photodiodes can directly face and approach the samples in the same heated thermostat. This invention saves a reliability tester one thermostat and a lot of fiber rods. Elimination of a thermostat and fiber rods effectively curtails the cost of production.

The saving of the thermostat and the fiber rods is not all of the merits of this invention. This invention is also favored with the high density of samples. The excellent thermal property of InGaAs photodiodes enables pairs of a laser and a photodiode to be arranged in the same thermostat. Thus several pairs of a laser and a photodiode can be aligned also in the axial direction (Y-direction)in the vessel. Of course pairs of a laser and a photodiode are disposed in the planes vertical to the axial direction. Therefore the pairs distribute in three dimensions in the thermostat. The photodiodes and the sample lasers are aligned along three axes. The thermostat of this invention can store several times as many lasers and photodiodes as the thermostat of the prior tester. High pack density of the photodetectors enhances the number of samples which are examined at a cycle. This invention succeeds in increasing the capacity of the tester and reducing the cost of test per sample.

In conclusion, this invention replaces Ge photodiodes with InGaAS photodiodes which excel in the smallness of a dark current at a test temperature. InGaAs photodetectors and sample lasers can be installed in the same thermostat. A plurality of pairs of a laser and a photodiode can be arranged in the axial direction. Three-dimensional distribution of the pairs enhances the pack density stored in a thermostat. The high pack density raises the number of the lasers which can be examined in one test cycle to a great extent, which curtails the test cost per sample. Elimination of a thermostat and fiber rods reduces the production cost.

The invention will be more fully understood from the following description given by way of example only with reference to the several figures of the accompanying drawings in which ;

Fig.1 is a horizontal section of a prior reliability tester of semiconductor lasers.

Fig.2 is a horizontal section of an embodiment of this invention.

Fig.3 is an enlarged, partially sectioned view of a pair of the laser and the photodiode in Fig.2.

Fig. 4 is a graph showing the change of the measured coupling efficiency as a function of the deviation of the axis of a laser diode from the axis of the photodiode.

Fig.5 is a horizontal section of another embodiment of this invention.

Fig.6 is an enlarged, partially sectioned view of a pair of the laser and the photodiode in Fig.5.

Fig.7 is an enlarged, partially sectioned view of a pair of the laser and the photodiode of another embodiment.

[EMBODIMENT 1]

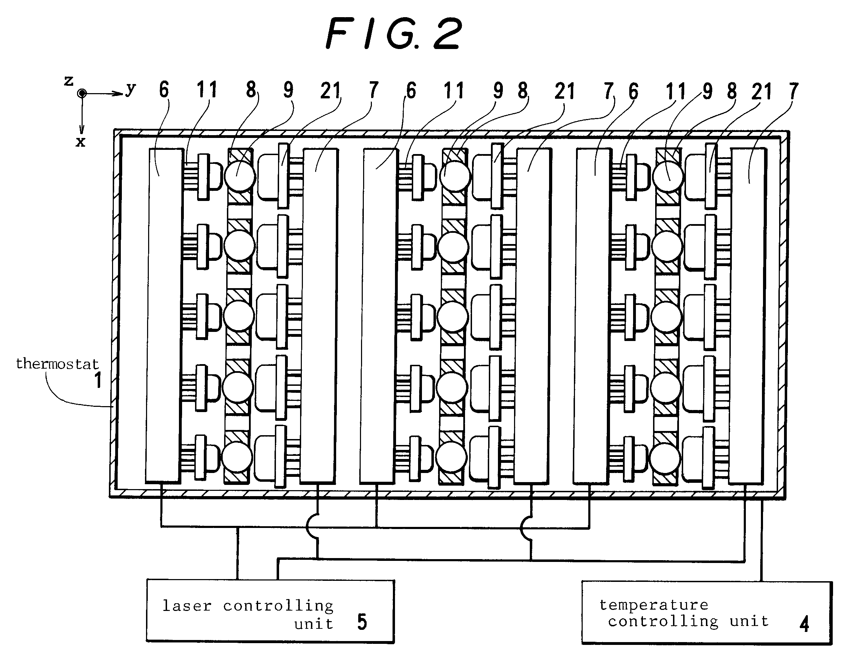

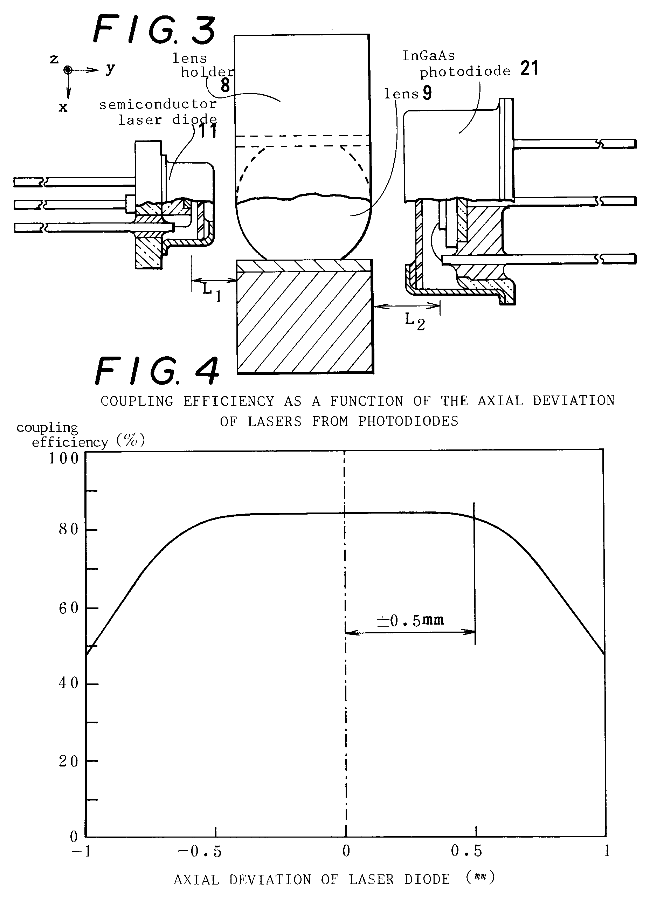

Fig.2 and Fig.3 demonstrate an embodiment of a reliability tester of semiconductor lasers. In Fig.2, the reliability tester has a single thermostat (1). A temperature controlling unit (4) maintains the thermostat (1) at a pertinent test temperature. For example, the temperature of the thermostat (1) is kept at a value in the range between 50°C and 100°C. A plurality of semiconductor lasers (11) are temporarily attached on laser print circuit plates (6) in the thermostat (1). The same number of InGaAs photodiodes (21) are installed on detector print circuit plates (7) in the same vessel (1). The smallness and the stability of the dark current allow the InGaAs photodiodes to be fixed in the heated thermostat (1). Every pair of a laser and a photodiode face each other with a short distance. The same number of lenses (9) are interposed between the lasers (11) and the detectors (21) by lens holders (8). The embodiment adopts ball lenses (9) as the converging optics. The laser (11) emanates light beams diverging in an imaginary cone. The lens (9) gathers and converges the beams on a receiving area of the corresponding InGaAs photodiode (21).

A laser controlling unit (5) supplies driving currents to the sample lasers (11) and detects the photocurrents of the photodiodes (21). The laser controlling unit has two different roles as a driving device and a monitoring device. The driving device supplies all sample lasers with driving currents. The monitoring device detects the photocurrents of all the photodiodes. The driving device and monitor device is integrated into the laser controlling unit in the embodiment.

The laser controlling unit (5) can control the laser driving currents and the photocurrents by two different modes of an ACC mode and an APC mode. In the case of the ACC mode, maintaining the driving currents at a constant, the laser controlling unit (5) detects the degradation of the sample lasers by measuring the photocurrents. A memory device records the time-dependent change of the photocurrents of all the samples.

In the case of the APC mode, the laser controlling unit (5) detects the degradation of the samples by measuring the driving currents, keeping the photocurrents at a constant value. A memory device records the time-dependent variations of driving currents of all the samples.

The reliability test finishes in a predetermined term. The lasers are detached from the print circuit plate. One cycle of test is ended. Other laser samples are newly attached to the circuit plate. The same test starts again.

In any cases, the reliability of the lasers can be obtained by the changes of the photocurrents or the driving currents. The laser power W is considered as function of time T and a driving current I. The relation is expressed by the equation $W = f(I,T)$. The ACC mode keeps the driving current I at a constant $I_c$. The ACC mode is simply defined by $W = f(I_c,T)$, where light power W is the object of the observation. The APC mode which maintains the power at a constant $W_c$ is similarly defined by $W_c = f(I,T)$, where the driving current I is the object of the observation.

Since this invention pairs a sample laser face to face with a photodiode with a short distance in a single thermostat, several pairs can be aligned also in the axial direction which is parallel with the light beams. Fig.2 demonstrates three pairs forming a line in the axial direction. The embodiment has three equivalent sets in Y-direction (axial direction). A set consists of a print circuit plate (6), a plurality of lasers (11), lenses (9), a lens holder (8), photodiodes (21) and a print circuit plate (7). The numbers of the lenses and the photodiodes are the same as that of the lasers. The length of one set is about 100 mm in Y-direction. Thus total length of the device in the axial direction is nearly 300 mm in the embodiment. The prior one shown by in Fig.1 needs 500 mm in the axial direction, though the prior one has only a single set in the direction. The pair-formation in a small space endows this invention with high packing density.

M denotes the number of pairs in X-direction. N denotes the number of paris in Z-direction. S designates the number of pairs in Y-direction. The number of the pairs attains MNS. On the contrary, the prior device of Fig.1 stores only MN pairs. This invention succeeds in increasing the number of pairs S times as many as the prior one which has the same volume.

Fig.3 is an enlarged view of a pair of a laser and a photodiode. The laser diode chip is sealed in a package. The photodiode chip is also sealed in another package. The packages hinders the chips from approaching each other. The InGaAs photodiode has a narrow receiving area which is insufficient to receive almost all beams emitted from the laser. Thus the lens gathers and converges the beams on the narrow receiving area of the photodiode.

The test processes and parameters are exemplified. The temperature of the thermostat is determined at a pertinent temperature between 50 °C and 120°C according to the object of the test. Practically the range of suitable temperature is 70°C to 100°C. For example, the thermostat is preset at 85°C which is a standard temperature of the reliability test of laser diodes. In the embodiment, the InGaAs photodiode has a receiving area of a diameter of 2 mm. The ball lens (9) is a TaF-3 lens of a 6 mm diameter. The laser controlling unit (5) detects the photocurrents of the photodiodes and maintains the light power at 5mW by adjusting the driving current. The light power relates to the photocurrent by a known relation. The driving currents are the object of the observation (APC). The laser controlling unit (5) measures the driving currents of all the sample lasers at a certain time interval. The time-dependent change of the driving currents signifies the long-term variation of the property of lasers. The long-term variation which gives the reliability of the lasers is recorded in a memory device.

L1 denotes the distance between the emission surface of the laser and the nearest spot of the lens. L2 denotes the distance between the receiving area of the photodiode and the nearest spot of the lens. The optimum values of L1 and L2 depend on the diameter of the receiving region of the photodiode, the refractive index of the lens and the curvature ( or radius) of the lens. Selections of the parameters L1 = 1mm to 5 mm and L2 = 1 mm to 10 mm enable more than 70 % of the light beams emitted from the laser to reach the receiving surface of the photodiode. For example, determination of L1 = 2.0 mm and L2 = 3.5 mm accomplishes 80 % of coupling efficiency, if the laser, the lens and the photodiode align without axial deviation. 80 % is a satisfactory efficiency for examining the reliability of lasers.

Axial deviation means the relative displacement of the laser in XZ-plane with regard to the counterpart photodiode. The axial deviation between the laser and the photodiode will drop the coupling efficiency to some extent. An axial deviation will always accompany the test. Therefore the influence of the axial deviation on the coupling efficiency has been investigated in the embodiment. Fig.4 shows the result of the measurement. The abscissa is the axial deviation (mm) of the laser diode from the standard position. The ordinate is the coupling efficiency (%). If the axial deviation is less than 0.5 mm, the photodiode couples with more than 80 % of efficiency to the sample laser diode. The convergence by the lens results in such a high coupling efficiency in a wide range of deviation. The interposition of the lens heightens the coupling efficiency and the margin of the axial deviation. Elimination of lens would reduce the coupling efficiency and the margin of the axial deviation. However the curve of Fig.4 demonstrates the case of the photodiode having the receiving area of a 2 mm diameter. Employment of the photodiodes with the receiving area of a diameter of 3 mm enhances the coupling efficiency and the margin for the axial deviation. The 3 mm diameter photodiode can dispense with a lens.

[EMBODIMENT 2]

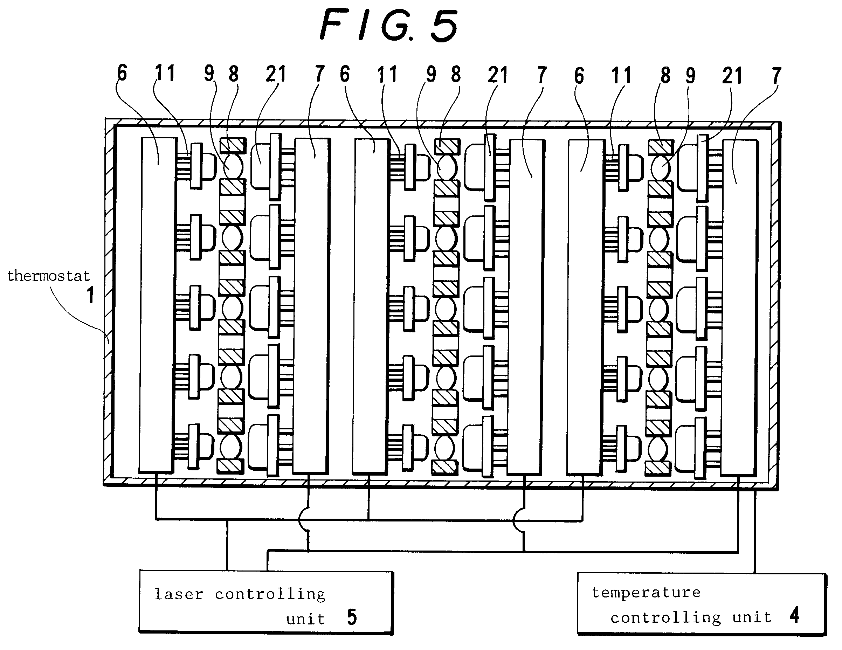

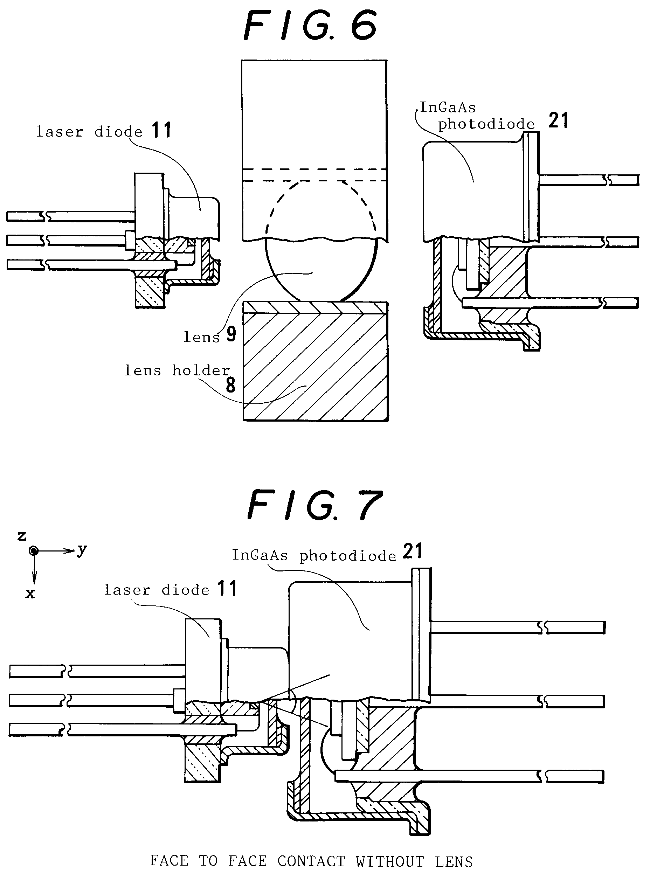

Another embodiment is given by Fig.5 and Fig.6. The embodiment comprises a thermostat (1), a plurality of photodiodes (21), lenses (9), and lasers (11) stored in the thermostat (1). Every laser (11) pairs up with a photodiode (21) in the vessel. The lasers (11) are disposed face to face with the counterpart (21). A lens (9) is interposed between the laser (11) and the photodiode (21) of a pair. The lens (9) is not a ball lens but an ordinary, convex lens. The temperature controlling unit (4) maintains the temperature of the thermostat (1) at 60 °C. This embodiment uses InGaAs photodiodes with a receiving area of a 1 mm diameter. The laser controlling unit (5) supplies the sample lasers with a constant driving current of 50 mA. The controlling unit (5) repeats detecting the photocurrents at a certain time interval for observing the light power of the semiconductor lasers. A memory device memorizes a series of the photocurrents. The controlling unit (5) includes the memory device.

The embodiment also arranges the pairs of a laser (11) and a photodiode (21) at the three-dimensionally distributed points. The three-dimensional distribution allows the embodiment to test a lot of lasers at one cycle. In the embodiment, the thermostat holds the pairs in three lines in the axial direction (Y-direction). Thus the embodiment has three times as large test capacity as the device of Fig.1. The production cost is alleviated by saving one thermostat and fiber rods. Embodiment 1 adopts ball lenses. Embodiment 2 employs non-ball, spherical convex lenses. Another types of lenses are also available, for example, a selfoc lens. This invention is not defined by the sort of lenses.

[EMBODIMENT 3]

Furthermore this invention can dispense with the lenses. Adoption of the photodiodes of large receiving areas enables the photodetector to gather almost all beams without lens. Elimination of lenses reduces the size of the thermostat and simplifies the inner structure of the thermostat. Fig.7 exhibits a pair of a laser and a photodiode of another embodiment without a lens. The plan view of the whole is neglected. Pairs of a laser and a photodiode distribute three-dimensionally like the embodiments shown by Fig.2 and Fig.5. Elimination of a lens allows the laser diode to come into contact or nearly contact with the photodiode. The contact type of coupling without a lens is suitable for the big photodiode having the receiving area of a diameter of about 3 mm.

**Claims**

1. A reliability tester of semiconductor lasers which emit light beams, comprising InGaAs photodiodes for receiving the light emitted from the lasers at receiving area and for producing photocurrents, a thermostat for storing both the photodiodes and the semiconductor lasers to be examined in facing relationship, a temperature controlling unit for controlling the temperature of the thermostat, a driver device for supplying driving currents to the laser and monitor device for detecting photocurrents of the InGaAs photodiodes.

2. A reliability tester as claimed in claim 1, wherein the lasers emit light beams of a wavelength of 1.0 $\mu$m to 1.6 $\mu$m.

3. A reliability tester as claimed in claim 2, wherein lenses are interposed between the photodiodes and the laser diodes and the lenses converge the light emitted from the lasers on receiving area of the photodiodes.

4. A reliability tester as claimed in claim 3, wherein the thermostat is heated to a temperature between 50°C and 120°C for accelerating the test.

5. A reliability tester as claimed in claim 3, wherein the photodiodes are two-dimensionally arranged on circuit plates, the lasers are two-dimensionally arranged on other circuit plates, the lenses are two-dimensionally arranged on lens holders and every set of a photodiode, a lens and a laser are aligned in a line parallel with the light beams.

6. A reliability tester as claimed in claim 1, wherein the photodiodes are two-dimensionally arranged on circuit plates, the lasers are two-dimensionally arranged on other circuit plates, and every pair of a photodiode and a laser are aligned in a line parallel with the light beams.

7. A reliability tester as claimed in claim 1, wherein the thermostat is heated at a temperature between 70°C and 100°C for accelerating the test.

8. A reliability tester as claimed in claim 5, wherein the lenses are ball lenses.

9. A reliability tester as claimed in claim 5, wherein the lenses are non-ball, spherical convex lenses.

10. A reliability tester as claimed in claim 5, wherein the lenses are selfoc lenses.

11. A reliability tester as claimed in claim 5, wherein the thermostat stores a plurality of sets of a laser circuit plate, plural lasers attached on the plate, a lens holder, plural lenses mounted on the holder, a photodiode circuit plate and plural photodiodes fixed on the plate and the sets are arranged along the line parallel with the light beams.

12. A reliability tester as claimed in claim 11, wherein the receiving area of the InGaAs photodiode has a diameter of 1 mm to 3mm.

13. A reliability tester as claimed in claim 12, wherein the lens is a ball lens.

14. A reliability tester as claimed in claim 6, wherein the thermostat stores a plurality of sets of a laser circuit plate, plural lasers attached on the plate, a photodiode circuit plate and plural photodiodes fixed on the plate and the sets are arranged along the line parallel with the light beams.

15. A reliability tester as claimed in claim 14, wherein the receiving region of the InGaAs photodiodes has a diameter of 2 mm to 3mm.

16. A reliability tester as claimed in claim 11, wherein the driving currents are kept at a constant, emission performance of the lasers is detected by the photocurrent of the photodiode.

17. A reliability tester as claimed in claim 11, wherein the photocurrents are kept at a constant, emission performance of the lasers is detected by the driving current.

# FIG. 1

EP 0 628 830 A2

FIG. 2

# FIG. 3

# FIG. 4

COUPLING EFFICIENCY AS A FUNCTION OF THE AXIAL DEVIATION
OF LASERS FROM PHOTODIODES

AXIAL DEVIATION OF LASER DIODE (mm)

11

FIG. 5

# F I G. 6

laser diode **11**

InGaAs photodiode **21**

lens **9**

lens holder **8**

# F I G. 7

z
y
x

laser diode **11**

InGaAs photodiode **21**

FACE TO FACE CONTACT WITHOUT LENS